# FASCICULE DE BREVET EUROPEEN

(11) **EP 4 006 996 B1**
(45) Date de publication et mention de la délivrance du brevet: **18.10.2023**
(21) Numéro de dépôt: 21209982.4
(22) Date de dépôt: 23.11.2021
(51) Int. Cl.: H10N 60/10, G06N 10/00

(54) **DISPOSITIF QUANTIQUE ET PROCÉDÉ DE RÉALISATION**
QUANTENVORRICHTUNG UND IHR HERSTELLUNGSVERFAHREN
QUANTUM DEVICE AND METHOD FOR MANUFACTURING SAME

(30) Priorité: 27.11.2020 FR 2012307
(43) Date de publication de la demande: 01.06.2022
(73) Titulaire: Commissariat à l'Energie Atomique et aux Energies Alternatives, 75015 Paris (FR)
(72) Inventeur: POSSEME, Nicolas, 38054 GRENOBLE Cedex 09 (FR); HUTIN, Louis, 38054 GRENOBLE Cedex 09 (FR); LE ROYER, Cyrille, 38054 GRENOBLE Cedex 09 (FR); LEFLOCH, François, 38054 GRENOBLE Cedex 09 (FR); NEMOUCHI, Fabrice, 38054 GRENOBLE Cedex 09 (FR); VINET, Maud, 38054 GRENOBLE Cedex 09 (FR)
(74) Mandataire: Hautier IP

(56) Documents cités:
- EP-A- 0 484 253
- KR-A- 20120 130 359
- US-A- 5 547 923
- US-A1- 2020 279 937

## Description

### DOMAINE TECHNIQUE

La présente invention concerne le domaine de l'électronique quantique. Elle trouve pour application particulièrement avantageuse la réalisation de grilles supraconductrices dans des dispositifs quantiques à bits quantiques (appelés quantum bits ou qubits), notamment pour des dispositifs basés sur des architectures à qubits de spin ou à qubits supraconducteurs.

### ETAT DE LA TECHNIQUE

Dans le domaine de l'électronique quantique, un bit quantique ou qubit correspond à un état quantique qui représente la plus petite unité de stockage d'information quantique. Cet état quantique est caractérisé par la superposition quantique de plusieurs états, notamment de l'état 0 et de l'état 1. En pratique le bit quantique peut être obtenu par différents dispositifs basés sur différentes architectures. Ainsi, il existe des qubits liés à un état quantique :
- d'un porteur de charge, par exemple le spin d'un électron ou d'un trou (qubit de spin),
- d'un courant circulant dans un supraconducteur, par exemple sa phase (qubit supraconducteur),
- d'un ion piégé ou d'un atome ou d'une molécule, par exemple son niveau énergétique,
- d'un photon, par exemple sa polarisation (qubit photonique).

Chaque type de dispositif possède des avantages intrinsèques et des inconvénients distincts. Par exemple, les dispositifs quantiques à qubits supraconducteurs permettent notamment d'obtenir une bonne intrication entre qubits. Cependant, ces dispositifs présentent encore une trop grande variabilité. Ils sont notamment sensibles aux petites imperfections induites par les procédés de fabrication. Ils requièrent notamment une interface de très grande qualité entre les deux réservoirs supraconducteurs, pour obtenir un effet Josephson. Il est également difficile de former un qubit unitaire via ces dispositifs.

Les dispositifs quantiques à qubits de spin peuvent fonctionner avec un nombre plus faible de qubits, et consommer moins d'énergie. Ils peuvent également bénéficier des procédés de fabrication et des technologies de la microélectronique pour améliorer la reproductibilité et augmenter la densité d'intégration de ces dispositifs à qubits de spin.

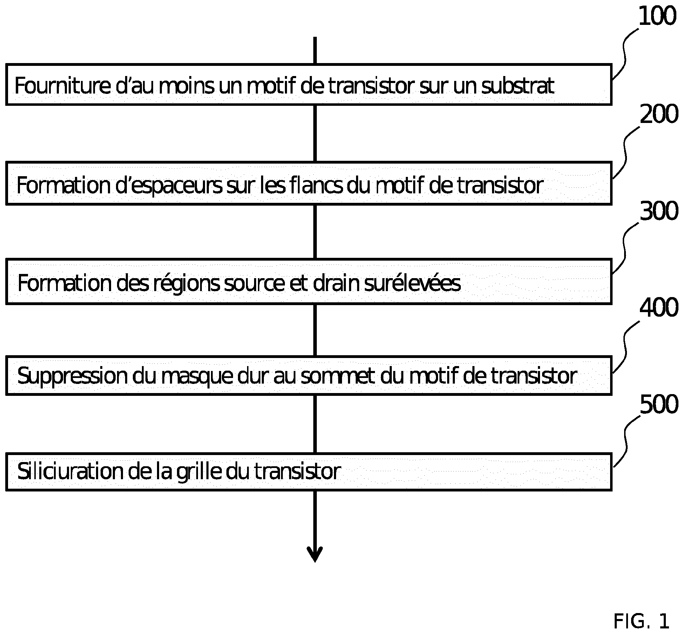

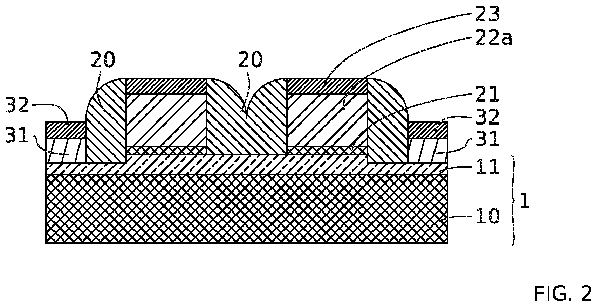

Le document « SOI technology for quantum information processing » de S. De Franceschi et al., Electron Devices Meeting (IEDM), 2016 IEEE International, pp. 13.4.1 - 13.4.4, décrit un dispositif quantique à qubits de spin réalisé selon un procédé de fabrication dérivé des technologies de transistors à canal totalement déplété (FDSOI). La figure 1 présente certaines étapes standard de fabrication d'un tel dispositif. Un ou plusieurs motifs de transistors comprenant chacun une grille et un diélectrique de grille sont formés 100 sur un substrat SOI. Des espaceurs sont ensuite formés 200 de part et d'autre des motifs de grille. Les régions de source et de drain surélevées sont formées 300 par épitaxie au bord des espaceurs. Après retrait 400 du masque dur sur le sommet de la grille, la grille est siliciurée 500. Ce procédé permet notamment de réaliser un dispositif quantique à deux qubits en série, dans une zone active 11 d'un substrat SOI 1, comme illustré à la figure 2. Les deux grilles 22a permettent de commander ces deux qubits. Les régions 31 de source et de drain forment des réservoirs de porteurs de charge pour ces deux qubits. Un tel dispositif quantique à qubits de spin présente néanmoins une vitesse de fonctionnement inférieure à celle d'un dispositif à qubits supraconducteurs.

Un autre exemple de l'art antérieur est le brevet EP0484253. Le document divulgue un transistor avec une grille supraconductrice , et une cavité sous la grille.

Un objet de la présente invention est de pallier au moins en partie certains des inconvénients mentionnés ci-dessus.

En particulier, un objet de la présente invention est de proposer un dispositif quantique diminuant la consommation d'énergie tout en améliorant la vitesse de fonctionnement.

Un autre objet de la présente invention est de proposer un procédé de réalisation d'un tel dispositif quantique.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du dispositif quantique peuvent s'appliquer *mutatis mutandis* au procédé, et réciproquement.

### RESUME

Pour atteindre cet objectif, selon un mode de réalisation on prévoit un premier aspect concerne un dispositif quantique comprenant un motif de transistor porté par un substrat, ledit motif de transistor comprenant, en empilement :
- un diélectrique de grille sur une face avant du substrat,
- une grille supraconductrice sur une face supérieure du diélectrique de grille, ladite grille présentant une base au contact de la face supérieure du diélectrique de grille, un sommet opposé à la base et des flancs s'étendant entre la base et le sommet, ladite grille comprenant au moins une région supraconductrice en un matériau à base d'au moins un élément supraconducteur.

Avantageusement, la grille comprend une portion basale et une portion supérieure, la portion basale s'étendant depuis la base jusqu'à la portion supérieure et la portion supérieure s'étendant depuis la portion basale jusqu'au sommet, la portion basale présentant une première dimension L_{22base}, prise selon une première direction x d'un plan basal xy, inférieure à une deuxième dimension L₂₂ₛᵤₚ de la portion supérieure, prise selon la première direction x, et inférieure à une dimension L₂₁₀ de la face supérieure du diélectrique de grille, prise selon la première direction x. La portion basale est ainsi en retrait vis-à-vis de la portion supérieure et vis-à-vis du diélectrique de grille, selon la première direction x, et ce retrait forme au moins une cavité. Le motif de transistor comprend en outre avantageusement au moins une portion diélectrique en un matériau diélectrique dans l'au moins une cavité.

Ainsi, la grille présente une portion rétrécie à sa base - la portion basale - permettant d'insérer un espaceur - la portion diélectrique - sous la portion supérieure de la grille. En coupe transverse, la portion basale peut présenter typiquement une forme de trapèze, avec la dimension la plus petite orientée vers le canal/ou au contact du diélectrique de grille. La portion supérieure est ainsi typiquement en surplomb de la portion basale, au-dessus de la portion diélectrique. La portion supérieure forme un débord vis-à-vis de la portion basale, selon la direction x . La portion diélectrique est sise sur le diélectrique de grille, sous la portion supérieure, et flanque la portion basale. Cela permet par exemple de former des régions source et drain au plus près du motif de transistor. Cela permet d'améliorer le contrôle électrostatique de la grille. Ainsi, il est notamment possible de réaliser un dispositif quantique à qubits de spin d'électrons. La grille supraconductrice du motif de transistor permet avantageusement de générer et moduler un champ magnétique compatible avec le contrôle de qubits de spin d'électrons.

Un deuxième aspect concerne un procédé de réalisation d'un dispositif quantique selon le premier aspect, comprenant les étapes suivantes :
- Fournir un substrat présentant une face avant et portant, en empilement sur sa face avant :
   - Une couche diélectrique en un matériau diélectrique présentant une face supérieure s'étendant selon un plan basal xy,
   - au moins une couche de grille un matériau de grille sur la face supérieure de la couche diélectrique, ladite au moins une couche de grille présentant une épaisseur e₂₂ selon une troisième direction z normale au plan basal xy,
- Former un masque dur sur l'au moins une couche de grille, le masque dur présentant des motifs de grille définissant les dimensions planaires d'au moins une grille,
- Graver partiellement de façon anisotrope selon la troisième direction z et sur une profondeur dₚ < e₂₂ selon ladite troisième direction z, l'au moins une couche de grille, de façon à former des flancs de grille au niveau d'une portion supérieure de grille,
- Graver de façon isotrope l'au moins une couche de grille sur une profondeur d'ₚ = e₂₂ - dₚ, de façon à exposer la face supérieure de la couche diélectrique et de façon à former au moins une cavité au niveau d'une portion basale de grille située sous le masque dur, en projection selon la troisième direction z, ladite au moins une cavité s'étendant selon une dimension L₂₃₀ selon la première direction x,
- Remplir l'au moins une cavité par un matériau diélectrique de façon à former au moins une portion diélectrique,
- Former une couche métallique à base d'au moins une espèce métallique au moins sur les flancs au niveau de la portion supérieure de la grille, ladite au moins une espèce métallique comprenant au moins un élément supraconducteur,
- Former une région supraconductrice dans la grille, par diffusion latérale de l'au moins un élément supraconducteur à partir des flancs de ladite grille, de façon à obtenir la grille supraconductrice.

Les procédés existants mettent généralement en oeuvre une étape de siliciuration de la grille à partir du sommet. Cela n'est pas adapté au contrôle de spin. Il est ici apparu qu'un bon contrôle de spin nécessitait la formation d'une région supraconductrice au plus près du canal, juste au-dessus du diélectrique de grille. Contrairement aux procédés de l'art antérieur, le procédé permet de former une telle région supraconductrice, par diffusion latérale à partir des flancs de la grille.

Cette diffusion latérale est effectuée à partir de la couche métallique comprenant au moins un élément supraconducteur.

Le procédé permet ainsi de réaliser un dispositif quantique présentant une architecture de transistor à grille supraconductrice.

Cela permet de réaliser un dispositif quantique à qubits de spin d'électrons présentant une vitesse de fonctionnement améliorée. La région supraconductrice formée par le procédé permet également de diminuer la consommation d'énergie du dispositif lors des opérations sur les qubits.

Il est également possible de réaliser un dispositif quantique à qubits supraconducteurs par le procédé. Un tel dispositif bénéficie dès lors des avantages liés à la mise en oeuvre du procédé via les technologies de l'industrie microélectronique. En particulier, la densité d'intégration d'un tel dispositif peut être augmentée.

Le dispositif quantique peut être avantageusement mis en oeuvre dans certaines applications, par exemple et de façon non limitative, telles que des applications transmon (qubit de charge supraconducteur), gatemon (transmon à polarisation variable) ou encore JoFET (FET- pour transistor à effet de champ- avec des régions source et drain supraconductrices).

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 présente un diagramme illustrant des étapes de réalisation d'un transistor selon un procédé de l'art antérieur.
La figure 2 présente schématiquement un dispositif quantique selon l'art antérieur obtenu à partir du procédé de réalisation de la figure 1.
La figure 3A illustre schématiquement un dispositif quantique selon un premier mode de réalisation de la présente invention.
La figure 3B illustre schématiquement un dispositif quantique selon un deuxième mode de réalisation de la présente invention
La figure 4 présente un diagramme illustrant des étapes de réalisation d'un dispositif quantique selon un mode de réalisation du procédé selon la présente invention.
Les figures 5A à 5D illustrent schématiquement des étapes de formation d'un dispositif quantique selon un premier mode de réalisation du procédé selon la présente invention.
La figure 5E illustre schématiquement des étapes de formation d'un dispositif quantique selon un deuxième mode de réalisation du procédé selon la présente invention.
La figure 5F illustre schématiquement une étape de formation d'un dispositif quantique selon un premier mode de réalisation du procédé selon la présente invention.
La figure 5G illustre schématiquement une étape de formation d'un dispositif quantique selon un deuxième mode de réalisation du procédé selon la présente invention.
La figure 5H illustre schématiquement des étapes de formation d'un dispositif quantique selon un premier mode de réalisation du procédé selon la présente invention.
La figure 5I illustre schématiquement des étapes de formation d'un dispositif quantique selon un deuxième mode de réalisation du procédé selon la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches, portions et éléments du dispositif (par exemple portion diélectrique ou espaceur, couche active, portion basale, portion supérieure, région source/drain, grille, masque dur) ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées séparément ou en combinaison :
Selon un exemple, la première dimension L_{22base} est une dimension minimale. Selon un exemple, la deuxième dimension L₂₂ₛᵤₚ est une dimension maximale.

Selon un exemple, les dimensions L₂₂₂ et L₂₁₀ du sommet de la grille et de la face supérieure du diélectrique de grille sont sensiblement égales entre elles.

Selon un exemple, la base présente une dimension L₂₂₀, prise selon la première direction x, égale à la dimension minimale L_{22base} de la portion basale.

Selon un exemple, les dimensions L₂₂₀, L_{22base} sont inférieures d'au moins 20% à la dimension L₂₂ₛᵤₚ.

Selon un exemple, les dimensions L₂₂₀, L_{22base} sont inférieures d'au moins 20% à la dimension L₂₁₀.

Selon un exemple, la dimension maximale L₂₂ₛᵤₚ de la portion supérieure et la dimension L₂₁₀ de la face supérieure du diélectrique de grille sont sensiblement égales entre elles.

Selon un exemple, le sommet présente une dimension L₂₂₂, prise selon la première direction x, égale à la dimension maximale L₂₂ₛᵤₚ de la portion supérieure.

Selon un exemple, les dimensions L₂₂ₛᵤₚ et/ou L₂₂₂ et/ou L₂₁₀ sont inférieures à 20 nm.

Selon un exemple, la portion diélectrique est au contact de la face supérieure du diélectrique de grille et au contact de la portion basale de la grille.

Selon un exemple, les flancs de la grille au niveau de la portion basale sont inclinés d'un angle α compris entre 30° et 60° par rapport au plan basal xy.

Selon un exemple, l'au moins une portion diélectrique présente au moins un flanc sensiblement en prolongement d'au moins l'un des flancs de la portion supérieure de la grille.

Selon un exemple, la base de la grille est sensiblement centrée vis-à-vis de la face supérieure du diélectrique de grille, selon la première direction x.

Selon un exemple, la portion basale présente une hauteur h_{base} prise selon une troisième direction z normale au plan basal xy, et la portion diélectrique présente une hauteur h₂₃ selon la troisième direction z sensiblement égale à h_{base} La hauteur h₂₃ peut être comprise entre 1 nm et 10 nm, de préférence entre 2 nm et 5 nm.

Selon un exemple, le dispositif quantique comprend en outre des régions source et drain comprenant au moins une région supraconductrice en un matériau à base d'au moins un élément supraconducteur par exemple tel que PtSi, Co₂Si, V₃Si.

Selon un exemple, les régions source et drain présentent un bord sensiblement à l'aplomb d'au moins un flanc de l'au moins une portion diélectrique.

Selon un exemple, le motif de transistor comporte une symétrie suivant un plan yz.

Selon un exemple, le motif de transistor comprend en outre un masque dur sur le sommet de la grille. Le masque dur peut notamment être conservé lors de la fabrication du dispositif pour empêcher une diffusion d'au moins une espèce métallique dans la grille à partir dudit sommet, de sorte que la formation de la région supraconductrice se fait uniquement par diffusion latérale à partir des flancs de la grille. Cela permet d'obtenir un front de diffusion relativement plan progressant depuis chacun des flancs jusque vers un plan médian au centre de la grille. Cela améliore la qualité de la région supraconductrice ainsi formée.

L'invention selon son deuxième aspect comprend notamment les caractéristiques optionnelles ci-après pouvant être utilisées en association ou alternativement :
Selon un exemple, le masque dur est retiré avant formation de la couche métallique, ladite couche métallique étant formée sur les flancs et le sommet de la grille, de sorte que la formation de la région supraconductrice se fait par diffusion latérale à partir des flancs de la grille et par diffusion à partir du sommet de la grille.

Selon un exemple, le matériau de grille est du silicium polycristallin.

Selon un exemple, la couche métallique formée comprend au moins un élément supraconducteur parmi du cobalt, du platine et du vanadium.

Selon un exemple, le procédé comprend, après formation de l'au moins une portion diélectrique, un retrait partiel de la couche diélectrique configuré pour exposer en partie la face avant du substrat et pour conserver une portion de ladite couche diélectrique sous le masque dur, en projection selon la troisième direction z, ladite portion formant le diélectrique de grille.

Selon un exemple, la couche métallique est formée sur la face avant exposée du substrat, après retrait partiel de la couche diélectrique, de façon à former par diffusion au moins une région supraconductrice au niveau de régions source et drain du substrat. Cela permet de former des régions source et drain supraconductrices dans une couche active du substrat, en même temps que la formation de la région supraconductrice dans la grille.

Selon un exemple, la diffusion latérale est configurée pour propager l'au moins un élément supraconducteur depuis chacun des flancs de la grille au moins jusqu'au centre de la grille, de façon à ce que la région supraconductrice soit formée sur toute une largeur L_{g} de la grille supraconductrice. La grille est ainsi totalement supraconductrice. Cela améliore le contrôle du dispositif quantique ainsi formé.

Selon un exemple, la grille présente une largeur L_{g} ≤ 20 nm et la couche métallique formée présente une épaisseur eₘ ≥ L_{g}/5. Cela permet d'avoir une quantité suffisante d'éléments supraconducteurs dans la couche métallique, de sorte que toute la grille puisse être rendue supraconductrice à l'issue de la diffusion latérale.

Selon un exemple, la couche métallique est formée par dépôt conforme de métal sur le motif de transistor et sur la face avant du substrat. Cela permet ensuite de former, typiquement par recuit de diffusion, des régions source et drain supraconductrices dans une couche active du substrat en même temps que la formation de la région supraconductrice dans la grille.

Selon un exemple, la couche métallique est formée par dépôt conforme de métal sur le motif de transistor et sur la couche diélectrique. Cela empêche une diffusion d'au moins un élément supraconducteur dans une couche active du substrat. Cela permet de former ou de siliciurer ultérieurement les régions source et drain. La formation de régions source et drain surélevées peut ainsi être envisagée.

Selon un exemple, la diffusion latérale se fait par recuit thermique, par exemple par recuit de type RCA (acronyme de Rapid Thermal Annealing).

Les conditions de diffusion latérale ou de siliciuration latérale peuvent notamment dépendre du métal utilisé et de la phase visée. Le tableau ci-dessous donne des exemples de rapport d'épaisseur entre différents métaux (le Co, Pt et V) et le silicium. L'ambiance de recuit peut être sous gaz inerte Ar, He ou N₂.

| Métal (nm) | Silicium (nm) | Siliciure formé (nm) | Game de T°C | Game de temps | Recuit sous Ar, He |
|---|---|---|---|---|---|
| | | | *Game avantageuse* | Game avantageuse | |
| Pt | Si | PtSi | 400°C à 700°C | 10s à 300s | 1 seul recuit de type RTA |
| 1.00 | 1.35 | 1.98 | 450°C à 550°C | 60s à 120s | |
| 2 Co | Si | Co₂Si | 550°C à 900°C | 10s à 300s | 2 étapes de recuit de type RTA |
| 1.00 | 0.91 | 1.47 | 600°C à 800°C | 60s à 120s | |
| V | Si | V3Si | 600°C à 1000°C | 10s à 1000s | 1 seul recuit de type RTA |
| 1.00 | 0.48 | 1.26 | 750°C à 850°C | 60s à 500s | |

Selon un exemple, le substrat porte une pluralité de motifs de transistors.

Selon un exemple, un sous-ensemble de la pluralité de motifs de transistors est masqué avant la formation de la couche métallique de sorte à éviter la formation de régions supraconductrices dans les grilles des motifs de transistors dudit sous-ensemble. Cela permet de co-intégrer des dispositifs quantiques avec des transistors, par exemple des transistors CMOS FDSOI, sur un même substrat.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif. En particulier, des éléments décrits ou illustrés sur les figures pour le dispositif ou pour le procédé peuvent être combinés de manière à former un autre mode de réalisation qui n'est pas nécessairement illustré ou décrit. Un tel mode de réalisation n'est évidemment pas exclu de l'invention.

Il est précisé que dans le cadre de la présente invention, le terme « sur », « surmonte », « recouvre » « sous » ou « sous-jacent » ou leurs équivalents ne signifient pas forcément « au contact de ». Ainsi par exemple, un masque dur sur une grille ne signifie pas obligatoirement que le masque dur et la grille sont directement au contact l'un de l'autre, mais cela signifie que le masque dur recouvre au moins partiellement la grille en étant soit directement à son contact soit en étant séparé d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant uniquement ce matériau M, ou ce matériau M et éventuellement d'autres matériaux, par exemple des éléments d'alliage, des impuretés ou des éléments dopants. Ainsi, un espaceur ou une portion diélectrique à base de nitrure de silicium SiN peut par exemple comprendre du nitrure de silicium non stoechiométrique (SiN), ou du nitrure de silicium stoechiométrique (Si3N4), ou encore un oxy-nitrure de silicium (SiON).

En général, mais non limitativement, un espaceur forme une bague autour de la grille, avec un contour fermé ; la portion diélectrique selon la présente invention peut typiquement correspondre à un tel espaceur. La description de la portion diélectrique s'entend de préférence d'une portion diélectrique unique autour de la grille ; cependant, les dessins d'illustration en coupe, généralement selon un plan parallèle à la direction longitudinale du canal, montrent deux parties d'espaceur ou de portion diélectrique de part et d'autre des flancs de la grille. Par extension, ces deux parties d'espaceur ou de portion diélectrique peuvent être désignées, dans le cas présent, par « les espaceurs » ou « les portions diélectriques ». Par ailleurs, l'invention s'étend aux modes de réalisation dans lesquels au moins deux espaceurs discontinus ou deux portions diélectriques discontinues flanquent une portion basale de grille.

La présente invention permet notamment la fabrication d'au moins un dispositif quantique ou d'une pluralité de dispositifs quantiques sur un substrat. Ce substrat peut être massif ou « bulk » selon la terminologie anglo-saxonne, ou encore de type semiconducteur sur isolant, par exemple un substrat silicium sur isolant SOI (acronyme de l'anglais « silicon on insulator ») ou un substrat germanium sur isolant GeOI (acronyme de l'anglais « germanium on insulator »). Ce substrat présente une « face avant » sur laquelle se trouve le le motif de transistor du dispositif quantique. Cette face avant n'est donc pas nécessairement exposée.

L'invention peut également être mise en oeuvre plus largement pour différents dispositifs ou composants micro-électroniques.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

Dans la présente demande, une figure peut illustrer plusieurs étapes ou sous-étapes.

Le terme « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Les termes « motif de grille », « empilement de grille », « grille » sont employés en synonymes.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Dans la présente demande de brevet, on parlera préférentiellement d'épaisseur pour une couche, de hauteur pour un dispositif (grille par exemple) et de profondeur pour une cavité ou une gravure. L'épaisseur est prise selon une direction normale au plan d'extension principale de la couche, la hauteur et la profondeur sont prises selon une direction normale au plan de base du substrat. Le plan d'extension principale de la couche, respectivement le plan de base du substrat, est généralement parallèle à une face inférieure ou une face supérieure de cette couche, respectivement de ce substrat.

Dans la présente demande de brevet, un repère de préférence orthonormé formé par les axes x, y, z est représenté sur les dessins d'accompagnement. Le substrat, plus précisément sa face inférieure et/ou sa face supérieure, s'étendent dans le plan basal xy.

Dans la suite, la hauteur et la profondeur sont prises selon la direction portée par l'axe z, la largeur est prise selon la direction portée par l'axe x.

Un élément situé « à l'aplomb » ou « au droit» ou « dans le prolongement» d'un autre élément signifie que ces deux éléments sont situés tous deux sur une même ligne perpendiculaire au plan basal, soit sur une même ligne orientée selon l'axe z sur les figures.

On entend par « horizontale » une orientation parallèle à un plan xy. On entend par « verticale » une orientation parallèle à l'axe z.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

L'invention va maintenant être décrite en détail au travers de quelques modes de réalisation non limitatifs.

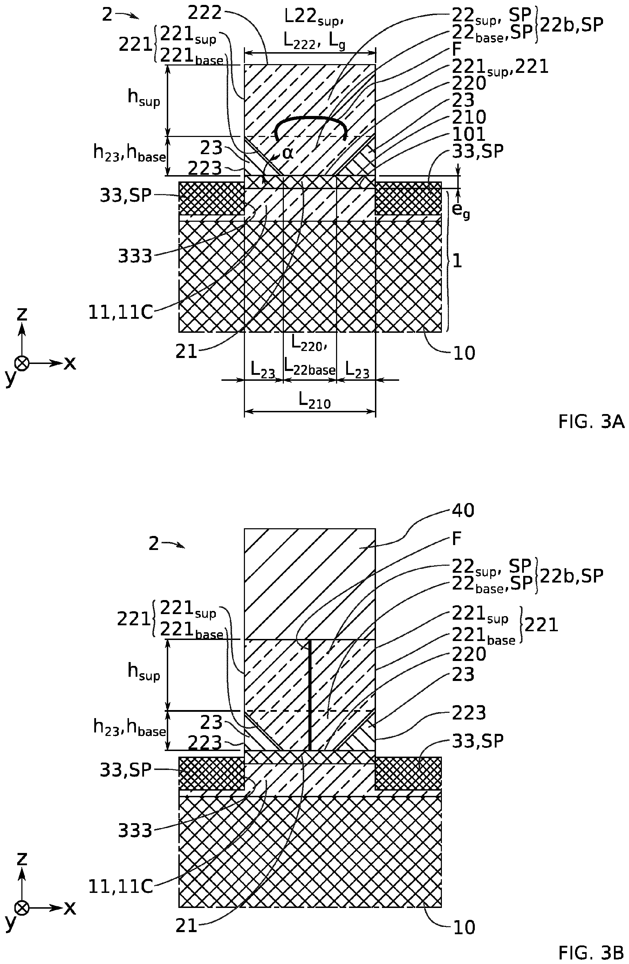

Un premier mode de réalisation du dispositif est illustré à la figure 3A. Un deuxième mode de réalisation du dispositif est illustré à la figure 3B. Ces deux modes de réalisation se différencient essentiellement par la présence d'un masque dur 40 et éventuellement par la forme du front de siliciuration F au sein de la grille supraconductrice 22b. Le masque dur 40 est notamment utile lors de la fabrication du dispositif. Il n'est pas destiné à être conservé lors de l'utilisation du dispositif. Il peut être enlevé à l'issue du procédé de réalisation du dispositif. Les autres caractéristiques décrites ci-dessous sont communes à ces deux modes de réalisation.

Comme illustré aux figures 3A, 3B, le dispositif comprend typiquement un motif de transistor 2 comprenant un diélectrique de grille 21 surmonté par une grille supraconductrice 22b. Ce motif de transistor 2 est porté par un substrat 1. Le substrat 1 est typiquement ici un substrat SOI comprenant une couche active 11 sur un oxyde enterré 10. Le diélectrique de grille 21 est typiquement à base de dioxyde de silicium SiO2, ou à base d'un matériau à haute constante diélectrique. Le diélectrique de grille 21 présente typiquement une épaisseur e_{g} comprise entre 1 nm et 5 nm. Il présente une face supérieure 210, opposée à une face de contact avec la face avant 101 du substrat 1. La face supérieure 210 est directement au contact de la grille 22b.

La grille 22b supraconductrice comprend une région supraconductrice SP à base de siliciure d'un métal supraconducteur, par exemple SiCo2, SiPt, SiV3. Cette région supraconductrice SP s'étend de préférence dans tout le volume de la grille 22b, de sorte que la grille 22b est totalement supraconductrice. La grille 22b présente deux portions 22ₛᵤₚ, 22_{base}, dites portion supérieure 22ₛᵤₚ et portion basale 22_{base} situées l'une au-dessus de l'autre. Les flancs 221 de la grille 22b présentent deux portions de flancs 221ₛᵤₚ, 221_{base}, correspondant respectivement aux portions supérieure 22ₛᵤₚ et basale 22_{base}.

La portion supérieure 22ₛᵤₚ présente typiquement une dimension L₂₂ₛᵤₚ selon x environ constante, et de préférence égale à la dimension L₂₂₂ du sommet 222. Cette dimension L₂₂ₛᵤₚ est inférieure à 25 nm et de préférence inférieure à 20 nm. La portion supérieure 22ₛᵤₚ présente une hauteur hₛᵤₚ comprise entre 15 nm et 200 nm environ.

La portion basale 22_{base} est plus étroite que la portion supérieure 22ₛᵤₚ, selon x. Elle présente une dimension L_{22base} inférieure à la dimension L₂₂ₛᵤₚ de la portion supérieure 22ₛᵤₚ. La portion basale 22_{base} s'étend jusqu'à la base 220 et présente notamment une dimension L₂₂₀ au niveau de la base 220 au moins 20% inférieure à la dimension L₂₂ₛᵤₚ de la portion supérieure 22ₛᵤₚ. Cette dimension L₂₂₀ est typiquement au moins 20% inférieure à la dimension L₂₁₀ de la face supérieure 210 du diélectrique de grille 21. La base 220 de la portion basale 22_{base} ne couvre pas entièrement la face supérieure 210 du diélectrique de grille 21. En particulier, la base 220 de la portion basale 22_{base} ne s'étend pas jusqu'au bord du diélectrique de grille 21, selon x. La portion basale 22_{base} peut présenter une forme tronconique comme illustré sur les figures 3A, 3B. Elle peut présenter une largeur selon x régulièrement décroissante entre la portion supérieure 22ₛᵤₚ et la base 220. Alternativement, elle peut présenter différentes formes et/ou différentes évolutions de largeur entre la portion supérieure 22ₛᵤₚ et la base 220. La forme de la portion basale 22_{base} est typiquement générée par gravure d'une couche plus massive dans laquelle sont formées des cavités, comme décrit plus loin. Dès lors, la forme de la portion basale 22_{base} dépend de la façon dont se développent les cavités. Une gravure préférentielle selon certains plans cristallographiques ou le long de certains joints de grain (par exemple dans le cas de silicium polycristallin) peut par exemple conduire à la formation de flancs 221_{base} inclinés d'un angle α par rapport à la face supérieure 210 ou au plan basal xy. Cet angle α peut être compris entre 30° et 60°, par exemple environ 45°. Les flancs 221_{base} ne sont pas nécessairement plans. La portion basale 22_{base} présente une hauteur h_{base} comprise entre 2 nm et 20 nm.

La largeur L_{g} de la grille 22b est typiquement égale à L₂₂ₛᵤₚ. La hauteur h_{g} de la grille 22b est typiquement égale à hₛᵤₚ + h_{base}.

Le dispositif comprend en outre des portions diélectriques 23, également appelées espaceurs. Ces espaceurs 23 remplissent typiquement les cavités précédemment citées. Ils sont en un matériau diélectrique, par exemple à base d'oxyde de silicium SiO2, de nitrure de silicium SiN, ou d'un autre matériau à faible constante diélectrique dit « low-k ». Ils peuvent éventuellement être formés d'une combinaison de ces différents matériaux, par exemple sous forme de multicouches. Les espaceurs 23 sont au contact des flancs 221_{base} et de la face supérieure 210 du diélectrique de grille 21. Ils peuvent présenter des flancs 223 sensiblement verticaux, en prolongement des flancs 221ₛᵤₚ de la portion supérieure 22ₛᵤₚ. Les espaceurs 23 présentent une dimension L₂₃ selon x par exemple comprise entre 2 nm et 5 nm.

Le dispositif peut en outre comprendre des régions 33 source et drain supraconductrices SP. Ces régions 33 source et drain supraconductrices peuvent être formées dans ou à partir de la couche active 11. Elles peuvent être avantageusement à base du même siliciure de métal supraconducteur que la grille 22b. Les régions 33 source et drain supraconductrices s'étendent de préférence selon l'axe x jusqu'à l'aplomb des flancs 23 et/ou des flancs 221ₛᵤₚ. En particulier, les régions 33 source et drain supraconductrices peuvent présenter un ou des bords 333 sensiblement verticaux, en prolongement des flancs 23 et/ou des flancs 221ₛᵤₚ. Cela permet de réduire la distance des régions 33 source et drain vis-à-vis du canal 11c sous le motif de transistor 2. La résistance d'accès au canal 11c est ainsi diminuée.

Dans le premier mode de réalisation du dispositif illustré à la figure 3A, le front de siliciuration F peut être en partie sensiblement parallèle au sommet 222. Cela indique typiquement que la région supraconductrice SP a été formée par diffusion à partir du sommet 222.

Dans le deuxième mode de réalisation du dispositif illustré à la figure 3B, le motif de transistor 2 est surmonté par un masque dur 40 typiquement à base de nitrure de silicium SiN ou de SiO2. Dans ce mode de réalisation, le front de siliciuration F peut être sensiblement vertical. Cela indique typiquement que la région supraconductrice SP a été formée par diffusion latérale à partir des flancs 221ₛᵤₚ.

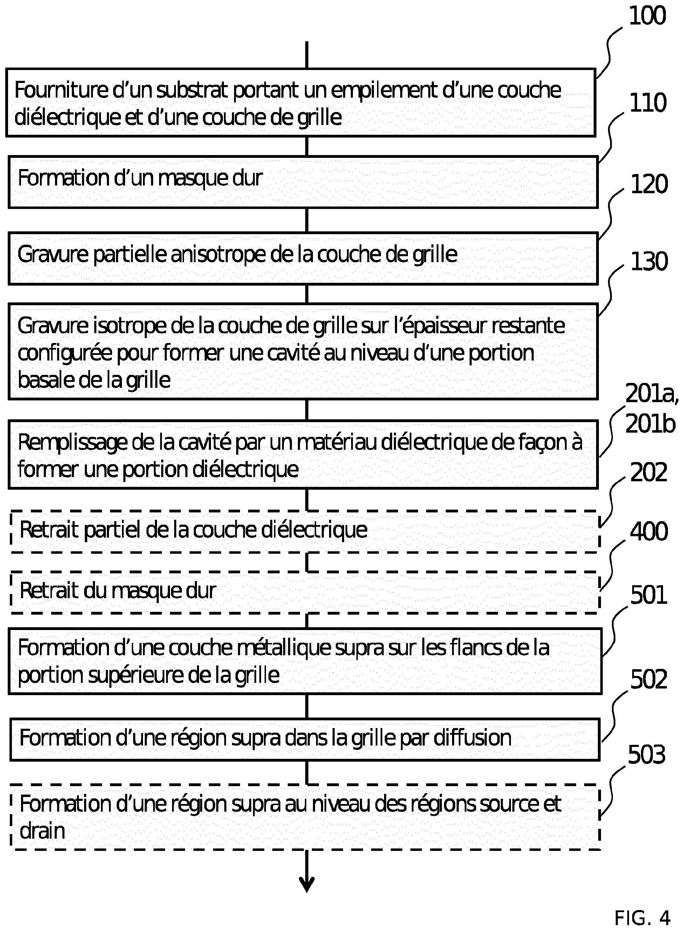

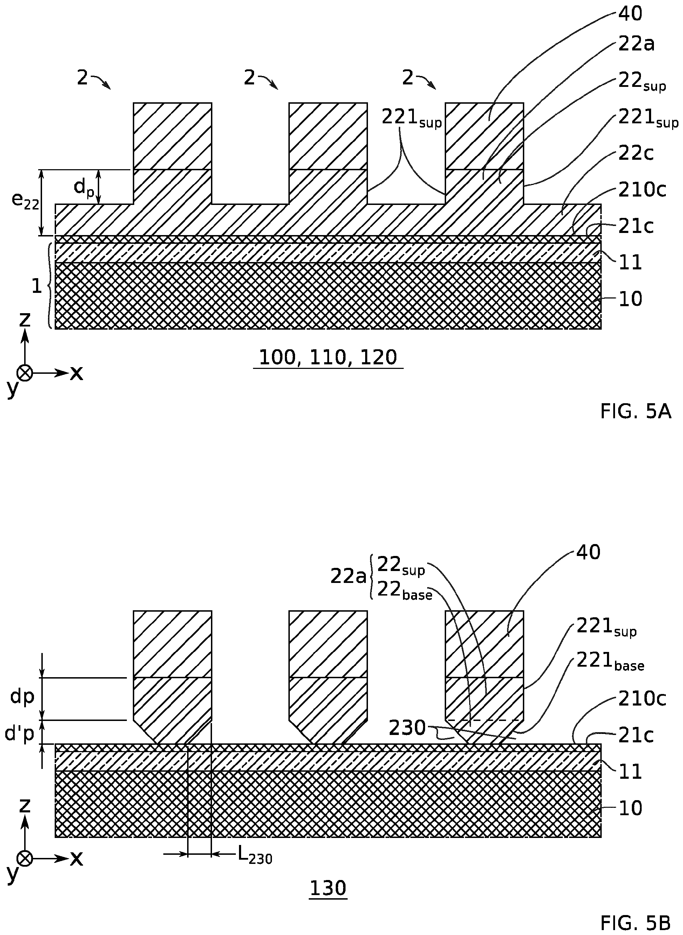

La figure 4 et les figures 5A à 5I illustrent des modes de réalisation du procédé selon l'invention. Ces modes de réalisation du procédé permettent notamment d'obtenir les dispositifs décrits plus haut, selon les premier et deuxième modes de réalisation.

Comme illustré à la figure 5A, un substrat 1 portant un empilement d'une couche diélectrique 21c et d'une couche de grille 22c est préalablement fourni 100. La couche diélectrique 21c peut être formée par oxydation ou par dépôt sur la face avant 101 du substrat 1, typiquement sur la couche active 11 d'un substrat 1 de type SOI. La couche de grille 22c peut être formée par dépôt sur la face supérieure 210c de la couche diélectrique 21c. La couche de grille 22c présente initialement une épaisseur e₂₂, par exemple comprise entre 20 nm et 200 nm. La couche de grille 22c est de préférence à base d'un seul matériau semiconducteur. Elle est typiquement à base de silicium polycristallin (polySi).

Un ou plusieurs masques durs 40 sont formés 110 sur cette couche de grille 22c de manière à définir des motifs de transistors 2. La formation 110 des masques durs 40 peut se faire de façon connue par lithographie/gravure.

La couche de grille 22c est ensuite partiellement gravée 120 par une première gravure sur une profondeur dₚ par exemple comprise entre 15 nm et 195 nm environ. La profondeur dₚ correspond sensiblement à la hauteur hₛᵤₚ de la portion supérieure 22ₛᵤₚ de la grille 22a en polySi. Cette première gravure partielle est anisotrope, dirigée selon z. Elle peut être effectuée par gravure plasma conventionnelle, par exemple à l'aide d'un plasma en chimie HBr/O2. Selon une autre possibilité, cette première gravure peut être effectuée par plasma en chimie fluorocarbonée ou à base de chlore, suivie par un plasma d'oxygène pour oxyder les flancs de la grille. La première gravure permet de former les flancs 221ₛᵤₚ de la portion supérieure 22ₛᵤₚ de la grille 22a en polySi. Les flancs 221ₛᵤₚ de la portion supérieure 22ₛᵤₚ sont typiquement oxydés à l'issue de cette première gravure. Les surfaces exposées de la couche de grille 22c sont typiquement oxydés à l'issue de cette première gravure.

Comme illustré à la figure 5B, la couche de grille 22c est ensuite gravée 130 de façon isotrope par une deuxième gravure sur l'épaisseur d'ₚ restante. Cette deuxième gravure est configurée pour former une ou des cavités 230 définissant la portion basale 22_{base} de la grille 22a en poly Si. Cette deuxième gravure peut comprendre une désoxydation préalable des surfaces horizontales exposées de la couche de grille 22c. Cette désoxydation peut se faire par un plasma à base d'Argon ou de CF4. La gravure isotrope de la couche de grille 22c peut ensuite se faire par un plasma à base de SF6, qui est sélectif à l'oxyde. Cette chimie à base de Fluor permet avantageusement de graver la couche de grille 22c de façon isotrope, sans graver les flancs 221ₛᵤₚ oxydés. Selon une autre possibilité, cette chimie peut être à base d'un mélange Fluorocarboné et SF6. La concentration de fluorocarbone peut être réduite progressivement au cours de la gravure de la couche de grille 22c. Cela permet de passiver les flancs 221_{base} (sous la portion supérieure 22ₛᵤₚ) et de réduire cette passivation au fur et à mesure de la gravure. Cela permet typiquement d'obtenir un profil incliné pour les flancs 221_{base}. Les cavités 230 formées à l'issue de cette deuxième gravure s'étendent sur une largeur L₂₃₀ selon x, typiquement comprise entre 2 nm et 5 nm. Cette deuxième gravure permet de former les flancs 221_{base} de la portion supérieure 22_{base} de la grille 22a en poly Si. La face supérieure 210c de la couche diélectrique 21c est typiquement exposée à l'issue de cette deuxième gravure.

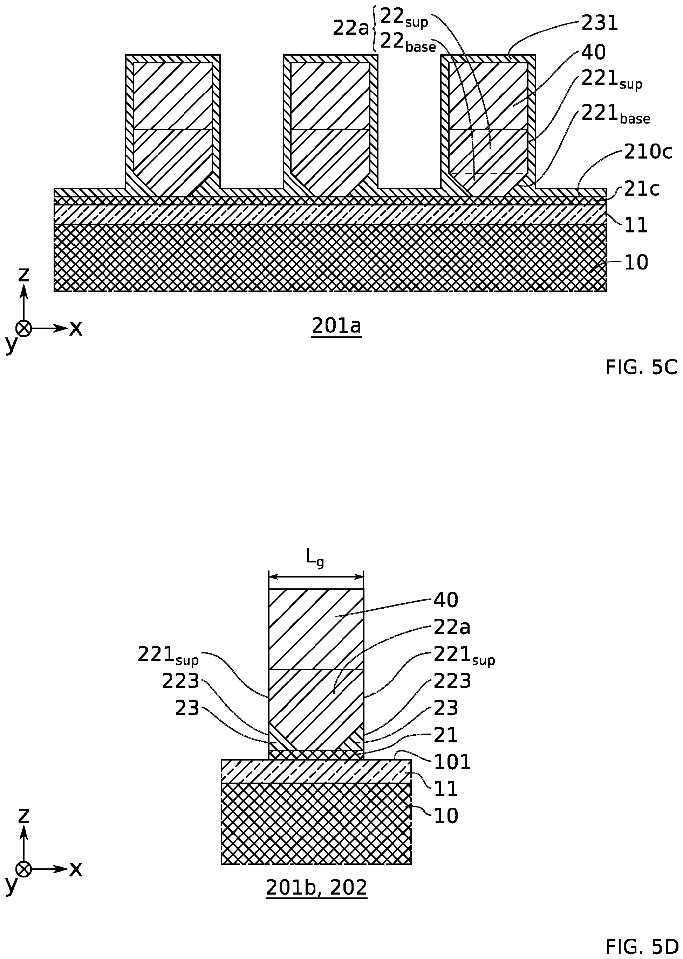

Comme illustré à la figure 5C, une couche 231 est ensuite déposée de façon à remplir 201a les cavités 230. Cette couche 231 est en un matériau d'espaceur, par exemple à base d'oxyde de silicium SiO2, de nitrure de silicium SiN, ou d'un autre matériau à faible constante diélectrique dit « low-k ». Selon une possibilité, la couche 231 peut comprendre plusieurs sous-couches formant un multicouches de matériaux d'espaceur. Elle est typiquement déposée de façon conforme, sur une épaisseur suffisante pour remplir les cavités 230.

Comme illustré à la figure 5D, la couche 231 est ensuite gravée, typiquement de façon anisotrope selon z, de façon à former 201b les portions diélectriques ou espaceurs 23. A l'issue de cette gravure, les espaceurs 23 présentent typiquement des flancs 223 sensiblement verticaux, en prolongement des flancs 221ₛᵤₚ de la portion supérieure 22ₛᵤₚ de la grille 22a en poly Si.

La couche diélectrique 21c est également gravée 202 de façon anisotrope, selon z. Cela permet de former le diélectrique de grille 21 sous le masque dur 40 et la grille 22a de largeur L_{g}. La face avant 101 du substrat 1 est exposée à l'issue de cette gravure.

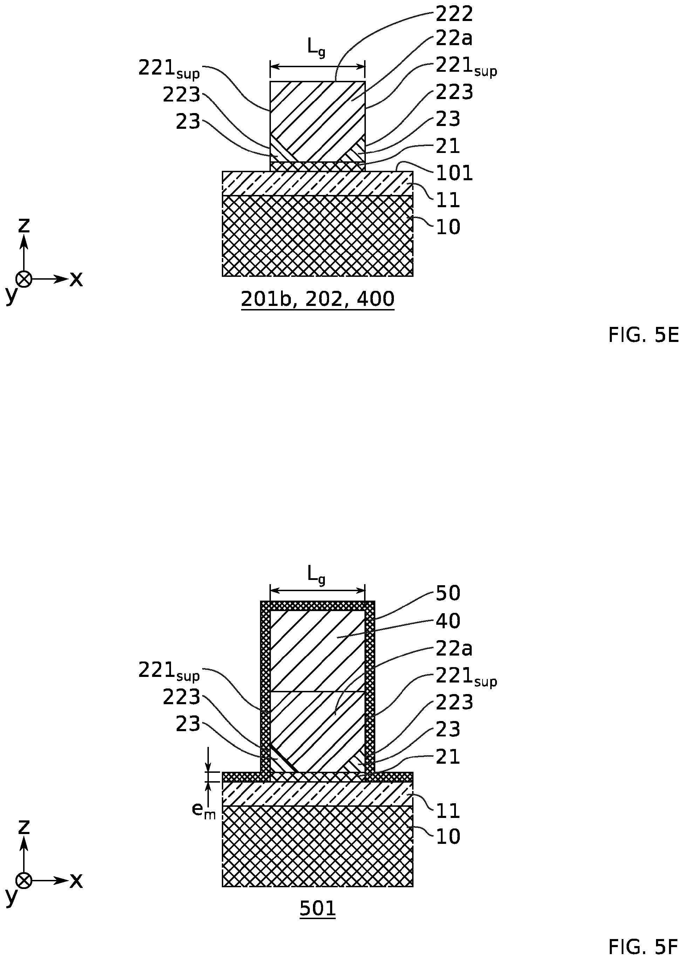

La figure 5E illustre une variante du procédé visant à obtenir le dispositif selon le premier mode de réalisation décrit plus haut. Selon cette variante, le masque dur 40 est retiré 400 de façon à exposer le sommet 222 de la grille 22a.

Les flancs 221ₛᵤₚ de la grille 22a, respectivement les flancs 221ₛᵤₚ et le sommet 222 de la grille 22a, sont exposés à l'issue de la gravure de la couche 231, respectivement à l'issue de la gravure de la couche 231 et du retrait du masque dur 40.

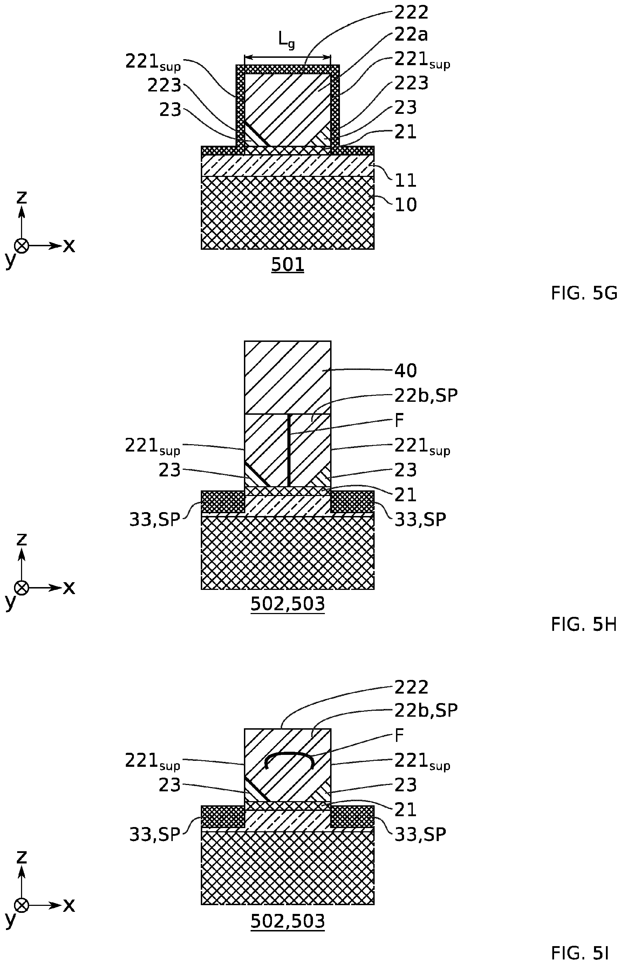

Les figures 5F, 5G illustrent la formation 501 d'une couche métallique 50 supraconductrice sur les deux variantes du dispositif illustrées aux figures 5D, 5E.

Un nettoyage préalable des flancs 221ₛᵤₚ et, le cas échéant, du sommet 222 peut être effectué, par exemple par plasma d'argon ou d'hélium, avant dépôt de la couche métallique 50. La couche métallique 50 peut être déposée de façon conforme sur les motifs de transistors 2, avec ou sans masque dur 40, et sur la couche active 11. La couche métallique 50 couvre au moins les flancs 221ₛᵤₚ. Cette couche métallique 50 comprend au moins un élément supraconducteur, par exemple pris parmi le cobalt, le platine ou le vanadium. Elle présente une épaisseur eₘ. Cette épaisseur eₘ est de préférence choisie de façon à ce que toute la grille 22a soit transformée en une région supraconductrice à l'issue de l'étape suivante de diffusion. En particulier, pour une grille 22a en polySi, le siliciure supraconducteur formé à partir de la diffusion latérale dans la grille 22a des éléments supraconducteurs de la couche métallique 50, par exemple le siliciure de cobalt CoSi2, le siliciure de platine PtSi, le siliciure de vanadium V3Si, présente une largeur Lₛᵤₚᵣₐ proportionnelle à la largeur L_{Si} de polySi consommé lors de la transformation, tel que Lₛᵤₚᵣₐ = α.Lₛᵢ, avec 1,5 ≤ α ≤ 2,5. Comme la diffusion s'effectue à partir de chacun des flancs 221ₛᵤₚ de la grille 22a, la largeur Lₛᵤₚᵣₐ requise pour transformer la grille 22a en région supraconductrice SP est égale à L_{g}/2. Dès lors, une épaisseur eₘ de couche métallique 50 supérieure ou égale à la largeur L_{Si} de polySi consommé lors de la transformation permet de siliciurer la grille 22a sur toute sa largeur L_{g}. On choisira donc de préférence eₘ ≥ L_{g}/2α, soit eₘ ≥ L_{g}/₅.

Les figures 5H, 5I illustrent la formation 502, 503 de régions supraconductrices SP au sein de la grille 22a et au sein de la couche active 11, sur les deux variantes du dispositif illustrées aux figures 5F, 5G.

La formation 501 de la région supraconductrice SP au sein de la grille 22a se fait au moins en partie par diffusion latérale des éléments supraconducteurs à partir des flancs 221ₛᵤₚ, c'est-à-dire principalement selon x. Cette diffusion latérale est de préférence configurée de façon à ce que la région supraconductrice SP soit formée sur toute la largeur L_{g} de la grille 22a, et sur toute la hauteur h_{g} de la grille 22a. La grille 22a devient dès lors une grille supraconductrice 22b.

Dans le cas illustré à la figure 5H, la diffusion se fait uniquement de façon latérale, et deux fronts de diffusion se développent depuis les deux flancs 221ₛᵤₚ de la grille 22a. Ces fronts de diffusion, dits latéraux, sont sensiblement verticaux et progressent en direction du plan médian yz de la grille 22a. La grille 22a est totalement transformée en grille supraconductrice 22b lorsque les fronts se rejoignent au niveau de ce plan médian yz. La présence du masque dur 40 empêche ici une diffusion des éléments supraconducteurs à partir du sommet de la grille 22a. Le front de siliciuration F, qui correspond à la jonction des fronts de diffusion, se trouve sensiblement dans le plan médian yz. Cela permet d'obtenir une grille 22b supraconductrice présentant une bonne qualité cristalline.

Dans le cas illustré à la figure 5I, la diffusion se fait à partir des flancs 221ₛᵤₚ et du sommet 222 de la grille 22a. Un troisième front de diffusion, dit sommital, se développe depuis le sommet 222. Le front de siliciuration F, qui correspond à la jonction des fronts de diffusion latéraux et sommital, présente un profil plus complexe que le cas illustré à la figure 5H. A un stade intermédiaire de la siliciuration, ce front de siliciuration F peut présenter un profil en U inversé. En fin de siliciuration, le front de siliciuration F présente typiquement un profil en I similaire à celui illustré à la figure 5H, mais de plus petites dimensions, typiquement moins long. Cette variante permet d'obtenir une grille 22b supraconductrice plus rapidement.

Selon une possibilité avantageuse, des régions supraconductrices SP sont également formées 503 par diffusion au sein de la couche active 11 lors de la formation 501 de la région supraconductrice SP au sein de la grille 22a. Ces régions supraconductrices SP deviennent dès lors des régions 33 source et drain supraconductrices. La diffusion des éléments supraconducteurs se fait ici à partir de la face avant 101 du substrat 1.

La diffusion des éléments supraconducteurs au sein de la grille 22a et/ou au sein de la couche active 11 se fait typiquement par recuit thermique, par exemple par recuit de type RCA.

Les conditions de diffusion latérale ou de siliciuration latérale peuvent notamment dépendre du métal utilisé et de la phase visée. Le tableau ci-dessous donne des exemples de rapport d'épaisseur entre différents métaux (le Co, Pt et V) et le silicium. L'ambiance de recuit peut être sous gaz inerte Ar, He ou N₂.

| Métal (nm) | Silicium (nm) | Siliciure formé (nm) | Game de T°C | Game de temps | Recuit sous Ar, He |
|---|---|---|---|---|---|
| | | | *Game avantageuse* | Game avantageuse | |
| Pt | Si | PtSi | 400°C à 700°C | 10s à 300s | 1 seul recuit type RTA |
| 1.00 | 1.35 | 1.98 | *450°C à 550°C* | 60s à 120s | |
| 2 Co | Si | Co₂Si | 550°C à 900°C | 10s à 300s | 2 étapes de recuit type RTA |
| 1.00 | 0.91 | 1.47 | *600°C à 800°C* | 60s à 120s | |
| V | Si | V3Si | 600°C à 1000°C | 10s à 1000s | 1 seul recuit type RTA |
| 1.00 | 0.48 | 1.26 | *750°C à 850°C* | 60s à 500s | |

Après formation 502, 503 des régions supraconductrices SP, les résidus métalliques sont de préférence nettoyés, par exemple à l'aide d'une solution à base d'eau oxygénée H2O2, comme un Caro (H₂O₂:H₂SO4), ou à l'aide de l'eau régal (HCl:HNO3) et/ou d'un mélange dit SC1 (H₂O:H₂O₂:NH₄OH). En fonction de la nature des éléments supraconducteurs, un nettoyage intermédiaire de résidus métalliques peut se faire lors de la formation 502, 503 des régions supraconductrices SP. Plusieurs recuits thermiques, par exemple avant et après nettoyage intermédiaire, peuvent dès lors être mis en oeuvre pour former 502, 503 les régions supraconductrices SP.

D'autres variantes du procédé non illustrées sont également envisageables.

Selon une possibilité, la couche diélectrique 21c est conservée avant dépôt 501 de la couche métallique 50 et lors de la formation 502 de la grille 22b supraconductrice. Cela évite que des éléments supraconducteurs diffusent au sein de la couche active 11. Dès lors, après retrait de la couche diélectrique 21c, des régions source et drain classiques peuvent être formées par siliciuration standard.

Selon une autre possibilité, des régions 33 source et drain surélevées, encore appelées RSD (pour Raised Source Drain) peuvent être formées.

Selon une autre possibilité, des transistors MOSFET FDSOI conventionnels et des dispositifs quantiques à grille supraconductrice peuvent être co-intégrés sur un même substrat 1. Cela peut être réalisé en masquant par une couche de masquage une partie des motifs de transistors 2 avant dépôt 501 de la couche métallique 50. Les grilles 22a de ces motifs de transistors 2 masqués sont ainsi préservées lors de la formation 502 des grilles 22b supraconductrices.

## Revendications

1. Dispositif quantique comprenant un motif de transistor (2) porté par un substrat (1), ledit motif de transistor (2) comprenant, en empilement :
- un diélectrique de grille (21) sur une face avant (101) du substrat (1),
- une grille (22b) supraconductrice sur une face supérieure (210) du diélectrique de grille (21), ladite grille (22b) présentant une base (220) au contact de la face supérieure (210) du diélectrique de grille (21), un sommet (222) opposé à la base (220) et des flancs (221) s'étendant entre la base (220) et le sommet (222), ladite grille (22b) comprenant au moins une région (SP) supraconductrice en un matériau à base d'au moins un élément supraconducteur,
le dispositif quantique étant **caractérisé en ce que** la grille (22b) comprend une portion basale (22_{base}) et une portion supérieure (22ₛᵤₚ), la portion basale (22_{base}) s'étendant depuis la base (220) jusqu'à la portion supérieure (22ₛᵤₚ) et la portion supérieure (22ₛᵤₚ) s'étendant depuis la portion basale (22_{base}) jusqu'au sommet (222), la portion basale (22_{base}) présentant une première dimension L_{22base}, prise selon une première direction (x) d'un plan basal (xy), inférieure à une deuxième dimension L₂₂ₛᵤₚ de la portion supérieure (22ₛᵤₚ), prise selon la première direction (x), et inférieure à une dimension L₂₁₀ de la face supérieure (210) du diélectrique de grille (21), prise selon la première direction (x), de sorte que la portion basale (22_{base}) soit en retrait vis-à-vis de la portion supérieure (22ₛᵤₚ) et du diélectrique de grille (21), selon la première direction (x), ce retrait formant au moins une cavité (230), et **en ce que** le motif de transistor (2) comprend en outre une portion diélectrique (23) en un matériau diélectrique dans l'au moins une cavité (230).

2. Dispositif quantique selon la revendication précédente dans lequel la base (220) présente une dimension L220, prise selon la première direction (x), égale à la dimension minimale L22base de la portion basale (22base), lesdites dimensions L220, L22base étant inférieures d'au moins 20% à la dimension L22sup.

3. Dispositif quantique selon l'une quelconque des revendications précédentes dans lequel la dimension maximale L22sup de la portion supérieure (22sup) et la dimension L210 de la face supérieure (210) du diélectrique de grille (21) sont sensiblement égales.

4. Dispositif quantique selon l'une quelconque des revendications précédentes dans lequel les dimensions L22sup et L210 sont inférieures à 20 nm.

5. Dispositif quantique selon l'une quelconque des revendications précédentes dans lequel la portion diélectrique (23) est au contact de la face supérieure (210) du diélectrique de grille (21) et au contact de la portion basale (22base) de la grille (22b) supraconductrice.

6. Dispositif quantique selon l'une quelconque des revendications précédentes dans lequel les flancs (221base) de la grille (22b) au niveau de la portion basale (22base) sont inclinés d'un angle α compris entre 30° et 60° par rapport au plan basal (xy).

7. Dispositif quantique selon l'une quelconque des revendications précédentes dans lequel la portion diélectrique (23) présente au moins un flanc (223) sensiblement en prolongement d'au moins l'un des flancs (221sup) de la portion supérieure (22sup) de la grille.

8. Dispositif quantique selon l'une quelconque des revendications précédentes dans lequel la base (220) de la grille est sensiblement centrée selon la première direction (x) vis-à-vis de la face supérieure (210) du diélectrique de grille (21), selon la première direction (x).

9. Dispositif quantique selon l'une quelconque des revendications précédentes dans lequel la portion basale (22base) présente une hauteur hbase, prise selon une troisième direction (z) normale au plan basal (xy), et la portion diélectrique (23) présente une hauteur h23 selon la troisième direction (z) sensiblement égale à hbase et de préférence comprise entre 1 nm et 10 nm.

10. Dispositif quantique selon l'une quelconque des revendications précédentes, comprenant en outre des régions (33) source et drain comprenant au moins une région (SP) supraconductrice en un matériau à base d'au moins un élément supraconducteur, par exemple tel que PtSi, Co2Si, V3Si.

11. Dispositif quantique selon la revendication précédente dans lequel les régions (33) source et drain présentent un bord (333) sensiblement à l'aplomb d'au moins un flanc (223) de l'au moins une portion diélectrique (23).

12. Procédé de réalisation d'un dispositif quantique défini selon l'une quelconque des revendications précédentes comprenant les étapes suivantes :
- Fournir (100) un substrat (1) présentant une face avant (101) et portant, en empilement sur sa face avant (101) :
• une couche diélectrique (21c) en un matériau diélectrique présentant une face supérieure (210c) s'étendant selon un plan basal (xy),
• une couche de grille (22c) en un matériau de grille sur la face supérieure (210c) de la couche diélectrique (21c), la couche de grille (22c) présentant une épaisseur e22 selon une troisième direction (z) normale au plan basal (xy),
- Former (110) un masque dur (40) sur la couche de grille (22c),
- Graver (120) partiellement de façon anisotrope selon la troisième direction (z) et sur une profondeur dp < e22 selon ladite troisième direction (z), la couche de grille (22c), de façon à former des flancs (221sup) de grille au niveau d'une portion supérieure (22sup) de grille (22a),
- Graver (130) de façon isotrope la couche de grille (22c) sur une profondeur d'p = e22 - dp, de façon à exposer la face supérieure (210c) de la couche diélectrique (21c) et de façon à former au moins une cavité (230) au niveau d'une portion basale (22base) de grille (22a) située sous le masque dur (40), en projection selon la troisième direction (z), ladite au moins une cavité (230) s'étendant selon une dimension L230 selon la première direction (x),
- Remplir (201a) l'au moins une cavité (230) par un matériau diélectrique de façon à former (201b) au moins une portion diélectrique (23),
- Former (501) une couche métallique (50) à base d'au moins une espèce métallique au moins sur les flancs (221sup) au niveau de la portion supérieure (22sup) de la grille (22a), ladite au moins une espèce métallique comprenant au moins un élément supraconducteur,
- Former (502) une région (SP) supraconductrice dans la grille (22a), par diffusion latérale de l'au moins un élément supraconducteur à partir des flancs (221sup) de ladite grille (22a), de façon à obtenir la grille (22b) supraconductrice.

13. Procédé selon la revendication précédente dans lequel le masque dur (40) est retiré (400) avant formation (501) de la couche métallique (50), ladite couche métallique (50) étant formée sur les flancs (221sup) et le sommet (222) de la grille (22a), de sorte que la formation (502) de la région (SP) supraconductrice se fait par diffusion latérale à partir des flancs (221sup) de la grille (22a) et par diffusion à partir du sommet (222) de la grille (22a).

14. Procédé selon l'une quelconque des revendications 12 ou 13 dans lequel le matériau de grille est du silicium polycristallin et la couche métallique (50) formée comprend au moins un élément supraconducteur parmi du cobalt, du platine et du vanadium.

15. Procédé selon l'une quelconque des revendications 12 à 14 comprenant, après formation (201b) de l'au moins une portion diélectrique (23), un retrait partiel (202) de la couche diélectrique (21c) configuré pour exposer en partie la face avant (101) du substrat (1) et pour conserver une portion de ladite couche diélectrique (21c) sous le masque dur (40), en projection selon la troisième direction (z), ladite portion formant le diélectrique de grille (21).

## Patentansprüche

1. Quantenvorrichtung, umfassend ein Transistormuster (2), das von einem Substrat (1) getragen wird, wobei das Transistormuster (2) in einem Stapel umfasst:
- ein Gate-Dielektrikum (21) auf einer vorderen Fläche (101) des Substrats (1);
- ein supraleitendes Gate (22b) auf einer oberen Fläche (210) des Gate-Dielektrikums (21), wobei das Gate (22b) eine Basis (220) im Kontakt mit der oberen Fläche (210) des Gate-Dielektrikums (21), eine Kuppe (222), die entgegengesetzt zu der Basis (220) ist, und Seiten (221), die sich zwischen der Basis (220) und der Kuppe (222) erstrecken, aufweist, wobei das Gate (22b) mindestens eine supraleitende Region (SP) aus einem Material auf der Basis mindestens eines Supraleiterelements umfasst,
wobei die Quantenvorrichtung **dadurch gekennzeichnet ist, dass** das Gate (22b) einen basalen Abschnitt (22_{Basis}) und einen oberen Abschnitt (22_{oben}) umfasst, wobei der basale Abschnitt (22_{Basis}) sich von der Basis (220) zu dem oberen Abschnitt (22_{oben}) erstreckt und der obere Abschnitt (22_{oben}) sich von dem basalen Abschnitt (22_{Basis}) zu der Kuppe (222) erstreckt, wobei der basale Abschnitt (22_{Basis}) eine erste Abmessung L_{22Basis}, genommen gemäß einer ersten Richtung (x) einer basalen Ebene (xy), aufweist, die kleiner als eine zweite Abmessung L_{22oben} des oberen Abschnitts (22_{oben}), genommen gemäß der ersten Richtung (x), und kleiner als eine Abmessung L₂₁₀ der oberen Fläche (210) des Gate-Dielektrikums (21), genommen gemäß der ersten Richtung (x), ist, so dass der basale Abschnitt (22_{Basis}) gegenüber dem oberen Abschnitt (22_{oben}) und dem Gate-Dielektrikum (21), gemäß der ersten Richtung (x), im abgehoben ist, wobei diese Abhebung mindestens eine Aussparung (230) bildet, und dass das Transistormuster (2) weiterhin einen dielektrischen Abschnitt (23) aus einem dielektrischen Material in der mindestens einen Aussparung (230) umfasst.

2. Quantenvorrichtung nach dem vorhergehenden Anspruch, wobei die Basis (220) eine Abmessung L220, genommen gemäß der ersten Richtung (x), aufweist, die gleich der minimalen Abmessung L22Basis des basalen Abschnitts (22Basis) ist, wobei die Abmessungen L220, L22Basis um mindestens 20 % kleiner als die Abmessung L22oben sind.

3. Quantenvorrichtung nach einem der vorhergehenden Ansprüche, wobei die maximale Abmessung L22oben des oberen Abschnitts (22oben) und die Abmessung L210 der oberen Fläche (210) des Gate-Dielektrikums (21) im Wesentlichen gleich sind.

4. Quantenvorrichtung nach einem der vorhergehenden Ansprüche, wobei die Abmessungen L22oben und L210 kleiner als 20 nm sind.

5. Quantenvorrichtung nach einem der vorhergehenden Ansprüche, wobei der dielektrische Abschnitt (23) im Kontakt mit der oberen Fläche (210) des Gate-Dielektrikums (21) und im Kontakt mit dem basalen Abschnitt (22Basis) des supraleitenden Gates (22b) ist.

6. Quantenvorrichtung nach einem der vorhergehenden Ansprüche, wobei die Seiten (221Basis) des Gates (22b) auf der Höhe des basalen Abschnitts (22Basis) mit einem Winkel α, der zwischen 30° und 60° liegt, in Bezug auf die basale Ebene (xy) geneigt sind.

7. Quantenvorrichtung nach einem der vorhergehenden Ansprüche, wobei der dielektrische Abschnitt (23) mindestens eine Seite (223) aufweist, die im Wesentlichen eine Verlängerung von mindestens einer der Seiten (221oben) des oberen Abschnitts (22oben) des Gates ist.

8. Quantenvorrichtung nach einem der vorhergehenden Ansprüche, wobei die Basis (220) des Gates im Wesentlichen gemäß der ersten Richtung (x) gegenüber der oberen Fläche (210) des Gate-Dielektrikums (21), gemäß der ersten Richtung (x), zentriert ist.

9. Quantenvorrichtung nach einem der vorhergehenden Ansprüche, wobei der basale Abschnitt (22Basis) eine Höhe hBasis, genommen gemäß einer dritten Richtung (z), die zu der basalen Ebene (xy) senkrecht ist, aufweist und der dielektrische Abschnitt (23) eine Höhe h23 gemäß der dritten Richtung (z) aufweist, die im Wesentlichen gleich hBasis ist und vorzugsweise zwischen 1 nm und 10 nm liegt.

10. Quantenvorrichtung nach einem der vorhergehenden Ansprüche, weiterhin umfassend Source- und Drain-Regionen (23), umfassend mindestens eine supraleitende Region (SP) aus einem Material auf der Basis eines Supraleiterelements, wie beispielsweise PtSi, Co2Si, V3Si.

11. Quantenvorrichtung nach dem vorhergehenden Anspruch, wobei die Source- und Drain-Regionen (33) einen Rand (333) aufweisen, der im Wesentlichen rechtwinklig zu mindestens einer Seite (223) des mindestens einen dielektrischen Abschnitts (23) ist.

12. Verfahren zur Herstellung einer nach einem der vorhergehenden Ansprüche definierten Quantenvorrichtung, umfassend die folgenden Schritte:
- Bereitstellen (100) eines Substrats (1), das eine vordere Fläche (101) aufweist und auf seiner vorderen Fläche (101) in einem Stapel trägt:
• eine dielektrische Schicht (21c) aus einem dielektrischen Material, die eine obere Fläche (210c) aufweist, die sich gemäß einer basalen Ebene (xy) erstreckt,
• eine Gate-Schicht (22c) aus einem Gate-Material auf der oberen Fläche (210c) der dielektrischen Schicht (21c), wobei die Gate-Schicht (22c) eine Dicke e22 gemäß einer dritten Richtung (z), die senkrecht zu der basalen Ebene (xy) ist, aufweist,
- Bilden (110) einer Hartmaske (40) auf der Gate-Schicht (22c),
- partielles anisotropes Ätzen (120) der Gate-Schicht (22c) gemäß der dritten Richtung (z) und zu einer Tiefe dp < e22 gemäß der dritten Richtung (z), um Seiten (221oben) des Gates auf der Höhe eines oberen Abschnitts (22oben) des Gates (22a) zu bilden,
- isotropes Ätzen (130) der Gate-Schicht (22c) zu einer Tiefe d'p = e22 - dp, um die obere Fläche (210c) der dielektrischen Schicht (21c) freizulegen und mindestens eine Aussparung (230) auf der Höhe eines basalen Abschnitts (22Basis) des Gates (22a), der sich unter der Hartmaske (40) befindet, zu bilden, wobei die mindestens eine Aussparung (230) sich gemäß einer Abmessung L230 gemäß der ersten Richtung (x) erstreckt,
- Füllen (201a) der mindestens einen Aussparung (230) mit einem dielektrischen Material, um mindestens einen dielektrischen Abschnitt (23) zu bilden,
- Bilden (501) einer Metallschicht (50) auf der Basis mindestens einer Metallspezies auf den Seiten (221oben) auf der Höhe des oberen Abschnitts (22oben) des Gates (22a), wobei die mindestens eine Metallspezies mindestens ein Supraleiterelement umfasst,
- Bilden (502) einer supraleitenden Region (SP) in dem Gate (22a) durch laterale Diffusion des mindestens einen Supraleiterelements ausgehend von den Seiten (221oben) des Gates (22a), um das supraleitende Gate (22b) zu erhalten.

13. Verfahren nach dem vorhergehenden Anspruch, wobei die Hartmaske (40) vor der Bildung (501) der Metallschicht (50) abgezogen wird, wobei die Metallschicht (50) auf den Seiten (221oben) und der Kuppe (222) des Gates (22a) gebildet wird, so dass die Bildung (502) der supraleitenden Region (SP) durch laterale Diffusion ausgehend von den Seiten (221oben) des Gates (22a) und durch Diffusion ausgehend von der Kuppe (222) des Gates (22a) erfolgt.

14. Verfahren nach einem der Ansprüche 12 oder 13, wobei das Gate-Material polykristallines Silizium ist und die gebildete Metallschicht (50) mindestens ein Supraleiterelement aus Kobalt, Platin und Vanadium umfasst.

15. Verfahren nach einem der Ansprüche 12 bis 14, umfassend, nach der Bildung (201b) des mindestens einen dielektrischen Abschnitts (23), eine partielle Abhebung (202) der dielektrischen Schicht (21c), die dazu konfiguriert ist, einen Teil der vorderen Fläche (101) des Substrats (1) freizulegen und einen Abschnitt der dielektrischen Schicht (21c) unter der Hartmaske (40) in einer Projektion gemäß der dritten Richtung (z) zu bewahren, wobei der Abschnitt das Gate-Dielektrikum (21) bildet.

## Claims

1. A quantum device comprising a transistor pattern (2) carried by a substrate (1), the transistor pattern (2) comprising, stacked on top of one another:
- a gate dielectric (21) on a front face (101) of the substrate (1),
- a superconducting gate (22b) on an upper face (210) of the gate dielectric (21), said gate (22b) having a base (220) in contact with the upper face (210) of the gate dielectric (21), a top (222) opposite to the base (220) and sidewalls (221) extending between the base (220) and the top (222), said gate (22b) comprising at least one superconducting region (SP) made of a material based on at least one superconducting element,
the quantum device being **characterised in that** the gate (22b) comprises a basal portion (22_{base}) and an upper portion (22ₛᵤₚ), the basal portion (22_{base}) extending from the base (220) up to the upper portion (22ₛᵤₚ) and the upper portion (22ₛᵤₚ) extending from the basal portion (22_{base}) up to the top (222), the basal portion (22_{base}) having a first dimension L_{22base}, considered according to a first direction (x) of a basal plane (xy), smaller than a second dimension L₂₂ₛᵤₚ of the upper portion (22ₛᵤₚ), considered according to the first direction (x), and smaller than a dimension L₂₁₀ of the upper face (210) of the gate dielectric (21), considered according to the first direction (x), so that the basal portion (22_{base}) is set back with respect to the upper portion (22ₛᵤₚ) and to the gate dielectric (21), according to the first direction (x), this setback forming at least one cavity (230), and **in that** the transistor pattern (2) further comprises a dielectric portion (23) made of a dielectric material in the at least one cavity (230).

2. The quantum device according to the preceding claim, wherein the base (220) has a dimension L220, considered according to the first direction (x), equal to the minimum dimension L22base of the basal portion (22base), said dimensions L220, L22base being at least 20% smaller than the dimension L22sup.

3. The quantum device according to any one of the preceding claims, wherein the maximum dimension L22sup of the upper portion (22sup) and the dimension L210 of the upper face (210) of the gate dielectric (21) are substantially equal.

4. The quantum device according to any one of the preceding claims, wherein the dimensions L22sup and L210 are smaller than 20 nm.

5. The quantum device according to any one of the preceding claims, wherein the dielectric portion (23) is in contact with the upper face (210) of the gate dielectric (21) and in contact with the basal portion (22base) of the superconducting gate (22b).

6. The quantum device according to any one of the preceding claims, wherein the sidewalls (221base) of the gate (22b) at the basal portion (22base) are inclined by an angle α comprised between 30° and 60° with respect to the basal plane (xy).

7. The quantum device according to any one of the preceding claims, wherein the dielectric portion (23) has at least one sidewall (223) substantially in line with at least one of the sidewalls (221sup) of the upper portion (22ₛᵤₚ) of the gate.

8. The quantum device according to any one of the preceding claims, wherein the base (220) of the gate is substantially centred according to the first direction (x) with respect to the upper face (210) of the gate dielectric (21), according to the first direction (x).

9. The quantum device according to any one of the preceding claims, wherein the basal portion (22base) has a height hbase, considered according to a third direction (z) normal to the basal plane (xy), and the dielectric portion (23) has a height h23 according to the third direction (z) substantially equal hbase and preferably comprised between 1 nm and 10 nm.

10. The quantum device according to any one of the preceding claims, further comprising source and drain regions (33) comprising at least one superconducting region (SP) made of a material based on at least one superconducting element, such as for example PtSi, Co2Si, V3Si.

11. The quantum device according to the preceding claim, wherein the source and drain regions (33) have an edge (333) that lies substantially vertically over at least one sidewall (223) of the at least one dielectric portion (23) .

12. A method for making a quantum device defined according to any one of the preceding claims, comprising the following steps:
- Providing (100) a substrate (1) having a front face (101) and carrying, stacked on its front face (101):
• a dielectric layer (21c) made of a dielectric material having an upper face (210c) extending according to a basal plane (xy),
• a gate layer (22c) made of a gate material on the upper face (210c) of the dielectric layer (21c), the gate layer (22c) having a thickness e22 according to a third direction (z) normal to the basal plane (xy),
- Forming (110) a hard mask (40) on the gate layer (22c),
- Partially anisotropically etching (120), according to the third direction (z) and over a depth dp < e22 according to said third direction (z), the gate layer (22c), so as to form gate sidewalls (221sup) at an upper portion (22sup) of the gate (22a),
- Isotropically etching (130) the gate layer (22c) over a depth d'p = e22 - dp, so as to expose the upper face (210c) of the dielectric layer (21c) and so as to form at least one cavity (230) at a basal portion (22base) of the gate (22a) located beneath the hard mask (40), in projection according to the third direction (z), said at least one cavity (230) extending according to a dimension L230 according to the first direction (x),
- Filling (201a) the at least one cavity (230) with a dielectric material so as to form (201b) at least one dielectric portion (23),
- Forming (501) a metal layer (50) based on at least one metal species at least on the sidewalls (221sup) at the upper portion (22sup) of the gate (22a), said at least one metal species comprising at least one superconducting element,
- Forming (502) a superconducting region (SP) in the gate (22a), by lateral diffusion of the at least one superconducting element from the sidewalls (221sup) of said gate (22a), so as to obtain the superconducting gate (22b).

13. The method according to the preceding claim, wherein the hard mask (40) is removed (400) before forming (501) the metal layer (50), said metal layer (50) being formed on the sidewalls (221sup) and the top (222) of the gate (22a), so that forming (502) the superconducting region (SP) is done by lateral diffusion from the sidewalls (221sup) of the gate (22a) and by diffusion from the top (222) of the gate (22a).

14. The method according to any one of claims 12 or 13, wherein the gate material is polycrystalline silicon and the formed metal layer (50) comprises at least one superconducting element selected from among cobalt, platinum and vanadium.

15. The method according to any one of claims 12 to 14, comprising, after forming (201b) the at least one dielectric portion (23), partially removing (202) the dielectric layer (21c) configured to partially expose the front face (101) of the substrate (1) and to keep a portion of said dielectric layer (21c) beneath the hard mask (40), in a projection according to the third direction (z), the portion forming the gate dielectric (21) .
